# FASCICULE DE BREVET EUROPEEN

(11) **EP 1 018 225 B1**
(45) Date de publication et mention de la délivrance du brevet: **19.12.2001**
(21) Numéro de dépôt: 98945379.0
(22) Date de dépôt: 25.09.1998
(51) Int. Cl.: H04B 7/005

(54) **PROCEDE DE GESTION DE L'ALIMENTATION D'UN POSTE DE RADIOTELEPHONIE CELLULAIRE**
VERFAHREN ZUR LEISTUNGSVERWALTUNG IN EINEM ZELLULAREN TELEPHONGERÄT
METHOD FOR MANAGING POWER SUPPLY TO A CELLULAR RADIOTELEPHONE STATION

(30) Priorité: 26.09.1997 FR 9712004
(43) Date de publication de la demande: 12.07.2000
(73) Titulaire: SAGEM SA, 75116 Paris (FR)
(72) Inventeur: THIERRY, Jean-Paul, F-95520 Osny (FR); PORATO, Marc, F-60240 Loconville (FR); DIMECH, Jean-Marc, F-60240 Chaumont en Vexin (FR); HEURTAUX, Frédéric, F-13610 Le Puy Sainte Réparade (FR)
(74) Mandataire: Bloch, Gérard
(86) Numéro de dépôt international: FR9802063
(87) Numéro de publication internationale: WO9917462

(56) Documents cités:
- WO-A-96/34461
- US-A- 5 465 399

## Description

Dans un réseau de radiotéléphonie cellulaire, comme le réseau GSM, les postes téléphoniques mobiles émettent vers les stations de base à un niveau de puissance qui dépend des caractéristiques de construction de chaque type de poste et qui sont définies par une classe de puissance.

Cette classe est mémorisée dans le poste et, lorsqu'on le met sous tension, il se déclare au réseau en émettant automatiquement cette classe et diverses données, indiquant ses caractéristiques et les fonctions qu'il supporte. Lorsqu'une communication est établie, le réseau pilote le niveau d'émission du poste en fonction de cette classe, c'est-à-dire que, en cas de réception faible au niveau de la station de base en liaison avec le poste, le réseau ne tentera de télécommander une augmentation du niveau d'émission du poste que si le niveau maximal d'émission associé à sa classe n'est pas déjà atteint. Sinon, le réseau tentera simplement de corriger les erreurs en réception.

Tant que le niveau maximal n'est pas atteint, le réseau télécommande le niveau d'émission du poste pour que celui-ci soit juste suffisant pour.éviter les erreurs, ce qui évite un gaspillage d'énergie du poste et favorise donc son autonomie.

L'émission radio représente une part importante de la consommation du poste, dont l'autonomie de l'alimentation stockant l'énergie électrique, piles ou accumulateurs, est très limitée. En cas de décharge prononcée, l'alimentation est incapable de fournir le courant voulu et il faut la changer ou la recharger.

La présente invention vise à prolonger la durée "de vie" d'une telle alimentation, c'est-à-dire accroître la quantité d'énergie utile que l'on peut en extraire, entre deux recharges si tel est le cas.

A cet effet, l'invention concerne un procédé de gestion de l'alimentation d'un poste d'un réseau de radiotéléphonie cellulaire, dont la puissance d'émission est commandée par le réseau en fonction d'une classe de puissance nominale indiquée par le poste, caractérisé par le fait que
- le niveau de charge de l'alimentation est déterminé,
- la puissance d'émission maximale pouvant être atteinte est déduite du niveau de charge,
- la puissance d'émission maximale et la puissance d'émission commandée par le réseau sont comparées, et
- le poste mobile est déclassé si celle-là est inférieure à celle-ci.

Ainsi, lorsque l'alimentation devient incapable de fournir la puissance voulue, on peut en poursuivre l'extraction d'énergie dans un mode de fonctionnement dégradé qui requiert moins de puissance.

Avantageusement, le poste se déclasse dans une classe fictive à puissance d'émission inférieure à celle de la classe nominale.

On peut ainsi retrouver un fonctionnement classique, à asservissement de puissance, mais dans une gamme plus faible de puissances d'émission.

Dans ce cas, de préférence, on coupe toute liaison entre le poste et le réseau pour ensuite rétablir une telle liaison et émettre l'indication relative à la classe fictive.

La commutation entre classes ne risque ainsi pas de perturber le réseau puisque ce dernier ne peut établir de lien logique entre le poste disparu et ce même poste, réapparaissant avec d'emblée une puissance réduite.

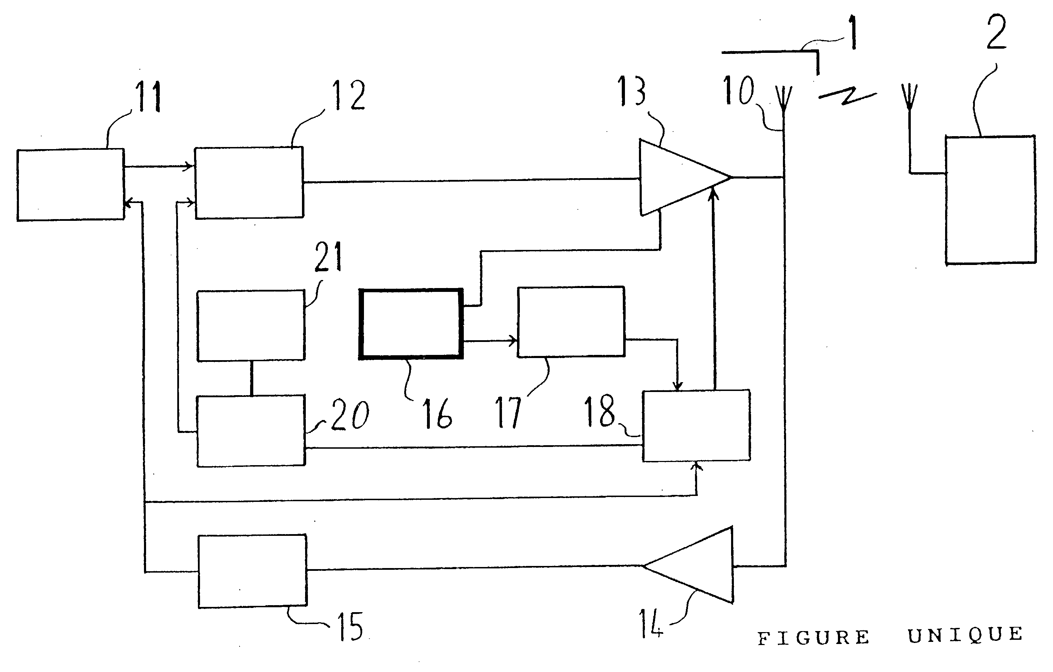

L'invention sera mieux comprise à l'aide de la description suivante d'un mode de mise en oeuvre préféré du procédé de l'invention, en référence à la figure unique qui représente schématiquement un poste de radiotéléphonie pour la mise en oeuvre du procédé de l'invention et une station radio de base.

Le poste 1 de réseau de radiotéléphonie cellulaire peut être relié à une station de base 2 du réseau, ici GSM. Le poste 1 comporte un ensemble classique 11 de circuits vocaux : circuits d'interface analogique, haut-parleur, microphone, ce dernier commandant, à travers un codeur 12, un amplificateur d'antenne 13 chargé par une antenne 10 d'émission-réception.

En réception, l'antenne 10 commande un amplificateur de réception 14 commandant le haut-parleur du circuit 11 à travers un décodeur 15.

L'ensemble des circuits représentés est alimenté par une source d'alimentation 16 stockant l'énergie électrique, ici un ensemble de piles. L'alimentation 16 alimente donc, en particulier, l'amplificateur 13, à puissance d'émission réglable contrôlée par un circuit 18 de réglage de gain, ou niveau de puissance, lui-même commandé par la sortie du décodeur 15 qui reçoit entre autres, à cet effet, des télécommandes provenant de la station 2.

Le niveau de charge de l'alimentation 16 est surveillé par un capteur 17 relié en sortie au circuit 18. Le capteur 17 mesure ici la tension de l'alimentation 16 ; dans d'autres exemples, il pourrait s'agir d'un ampèremètre ou encore d'un capteur de température, existant déjà pour des questions de sécurité.

En outre, un microprocesseur 20, gérant l'ensemble des circuits, est relié à une mémoire morte 21, contenant des données d'identification du terminal 1, qui peut être lue par le codeur 12 à travers le microprocesseur 20.

Le fonctionnement du poste 1 est le suivant, en ce qui concerne la gestion de l'alimentation 16.

Lorsque le poste 1 est actif et reçoit des télécommandes de réglage de niveau d'émission (13), le niveau de charge de l'alimentation 16 est déterminé, la puissance d'émission maximale pouvant être atteinte est déduite du niveau de charge, la puissance d'émission maximale et la puissance d'émission commandée (14) par le réseau 2 sont comparées, et le poste mobile 1 est déclassé si celle-là est inférieure à celle-ci (14).

Le déclassement peut consister à adopter une autre classe prédéterminée, en passant de 2 watts à 0,8 watt par exemple, ou, simplement, à ne pas atteindre le niveau voulu en émission, en refusant d'exécuter les ordres de télécommande, sans pour autant que le niveau réel d'émission, ou le niveau maximal, corresponde à une classe prédéterminée. Dans ce dernier cas, de préférence on émettra au niveau maximal possible compte tenu du niveau de charge de l'alimentation, afin de se rapprocher au mieux du niveau attendu par la station 2.

Par contre, dans le cas où l'on passe à une classe inférieure déterminée, le niveau requis par la station 2 va être réduit après que le poste 1 lui a transmis la nouvelle classe, si bien que les ordres de télécommande (d'augmentation) du niveau de puissance qu'elle émet seront à nouveau exécutés puisqu'une marge de sécurité aura été reconstituée par l'abaissement de la classe. Le processus de réduction de classe peut se poursuivre sur d'autres classes inférieures. Lors du déclassement, le réseau peut par exemple affecter le poste 1 à une autre station, plus proche de lui que ne l'est la station 2, même si cette autre station est plus encombrée, afin d'améliorer la qualité des liaisons.

Le processus de gestion de l'alimentation 16 va être expliqué plus en détails.

Lorsque le poste 1 est mis sous tension, il se déclare à la station 2 en émettant ses données d'identification contenues dans la mémoire 21. Le réseau 2 connaît ainsi la classe du poste 1, c'est-à-dire la puissance maximale qu'il peut lui demander d'émettre. Lors des déplacements du poste 1, le réseau 2 peut ainsi télécommander le circuit 18 pour ajuster la puissance d'émission (13) à un niveau suffisant pour une bonne réception à la station 2, sans toutefois gaspiller l'énergie par une émission à niveau excessif.

Si la station 2 ne reçoit du poste 1 qu'un niveau trop faible, elle émet un ordre de télécommande pour en remonter le niveau d'émission (13). Si, dans le cas qui nous intéresse ici, l'alimentation 16 a un niveau de charge insuffisant pour fournir la puissance d'émission correspondant au niveau voulu, le poste 1 est alors déclassé.

Le niveau de charge est ici estimé d'après la tension de l'alimentation 16, qui chute à mesure qu'elle se décharge. Le circuit 17 mesure en particulier la tension au repos, à faible décharge, en l'absence d'émission, ce qui fournit une première estimation sur le niveau de charge, et mesure aussi la tension à débit élevé, en émission, ce qui fournit une seconde indication sur le niveau de charge, en estimant en fait la résistance interne de l'alimentation 16 puisque le courant absorbé normalement par l'antenne 10 et les divers circuits est connu.

Le circuit 18 exploite alors ces mesures pour accepter ou refuser un ordre de télécommande visant à augmenter le niveau d'émission. Pour modifier la classe annoncée au réseau 2, le circuit 18 commande le microprocesseur 20, qui émet alors une indication de classe fictive (ou de puissance maximale) inférieure à celle en mémoire 21. Il peut être prévu que l'on coupe l'alimentation du poste 1, ou que le microprocesseur 20 commande une telle coupure par un interrupteur non représenté, poste 1 qui "disparaît" ainsi du réseau 2, pour ensuite réapparaître par rétablissement de son alimentation, en annonçant la classe fictive, ici 0,8 watt, ce qui évite de risquer de perturber le réseau 2 par une transition de classes qu'il détecterait si l'on maintenait la liaison avec lui. En variante, il suffit simplement de couper puis rétablir la liaison entre le poste 1 et le réseau 2.

Si la décharge de l'alimentation 16 est trop accentuée, on peut encore interdire toute émission de signaux vocaux et ne maintenir que la réception de messages provenant du réseau 2, par exemple les messages courts écrits, c'est-à-dire qu'on interdit tout appel sortant tout en autorisant les émissions de signalisations pour gérer les appels entrants. Le poste 1 fonctionne alors en récepteur de messages (pager), son utilisateur étant informé de l'identité des correspondants qui l'appellent.

On détecte alors dans les messages reçus, constitués du message envoyé par le poste appelant et de signalisations l'identifiant, le numéro d'appel téléphonique identifiant le poste appelant et on l'applique à des moyens de relation homme-machine, comme un afficheur ou un synthétiseur vocal.

Pour encore économiser l'énergie, on peut même interdire toute émission, même des signalisations de gestion des appels entrants. On détecte simplement l'arrivée d'un appel et on le signale par un moyen du genre indiqué ci-dessus, par exemple un buzzer.

En pratique, le circuit de réglage 18 peut n'exister que fonctionnellement, c'est-à-dire être intégré au microprocesseur 20 ou à une unité centrale équivalente gérant le réglage de l'émetteur 13 en partage de temps.

## Revendications

1. Procédé de gestion de l'alimentation (16) d'un poste téléphonique mobile (1), d'un réseau de radiotéléphonie cellulaire (2), dont la puissance d'émission (13) est commandée (14) par le réseau (2) en fonction d'une classe de puissance indiquée par le poste (1), procédé **caractérisé par le fait que**
- le niveau de charge de l'alimentation (16) est déterminé,
- la puissance d'émission maximale pouvant être atteinte est déduite du niveau de charge,
- la puissance d'émission maximale et la puissance d'émission commandée (14) par le réseau (2) sont comparées, et
- le poste mobile (1) est déclassé si celle-là est inférieure à celle-ci (14).

2. Procédé selon la revendication 1, dans lequel, pour se déclasser, le poste (1) rejette la commande de puissance du réseau.

3. Procédé selon la revendication 1, dans lequel le poste (1) se déclasse dans une classe fictive à puissance d'émission inférieure à celle de la classe nominale.

4. Procédé selon la revendication 3, dans lequel on coupe toute liaison entre le poste (1) et le réseau (2) pour ensuite rétablir une telle liaison et émettre l'indication relative à la classe fictive.

5. Procédé selon la revendication 4, dans lequel on coupe la liaison par coupure de l'alimentation (16) du poste (1).

6. Procédé selon l'une des revendications 1 à 5, dans lequel on estime la puissance d'émission maximale d'après le courant débité par l'alimentation (16).

7. Procédé selon l'une des revendications 1 à 5, dans lequel on estime ladite puissance d'émission maximale d'après la tension de l'alimentation (16).

8. Procédé selon l'une des revendications 1 à 5, dans lequel on estime ladite puissance d'émission maximale d'après la température de l'alimentation (16).

9. Procédé selon la revendication 1, dans lequel le poste (1) est déclassé en interdisant toute émission de signaux vocaux et on maintient la réception de messages provenant du réseau (2).

10. Procédé selon la revendication 9, dans lequel, le poste (1) comportant des moyens de relation homme-machine, on détecte, dans les messages, un numéro identifiant un poste appelant, que l'on applique aux moyens de relation homme-machine.

11. Procédé selon la revendication 9, dans lequel, le poste (1) comportant des moyens de relation homme-machine, on interdit toute émission et on détecte l'arrivée d'un appel, que l'on signale par les moyens de relation homme-machine.

## Patentansprüche

1. Verfahren zur Verwaltung der Stromversorgung (16) eines Mobiltelefongeräts (1), eines zellulären Funktelefonnetzes (2), dessen Sendeleistung (13) durch das Netz (2) als Funktion einer Leistungsklasse gesteuert (14) wird, die durch das Gerät (1) angegeben ist, wobei das Verfahren
**dadurch gekennzeichnet ist, dass**
- das Ladeniveau der Stromversorgung (16) bestimmt ist,
- die maximale Sendeleistung, die erreicht werden kann, vom Ladeniveau abgeleitet ist,
- die maximale Sendeleistung und die Sendeleistung, die durch das Netz (2) gesteuert (14) wird, verglichen werden und
- das Mobilgerät (1) deklassiert wird, falls die maximale Sendeleistung niedriger als die durch das Netz (2) gesteuerte (14) Sendeleistung ist.

2. Verfahren nach Anspruch 1,
wobei das Gerät (1), um sich zu deklassieren, die Leistungssteuerung des Netzes zurückweist.

3. Verfahren nach Anspruch 1,
wobei das Gerät (1) in eine fiktive Klasse mit einer Sendeleistung deklassiert, die niedriger als diejenige der Nennklasse ist.

4. Verfahren nach Anspruch 3,
wobei jegliche Verbindung zwischen dem Gerät (1) und dem Netz (2) getrennt wird, um anschließend eine derartige Verbindung wieder aufzubauen und die Anzeige bezüglich der fiktiven Klasse zu senden.

5. Verfahren nach Anspruch 4,
wobei die Verbindung durch Trennen der Stromversorgung (16) des Geräts (1) unterbrochen wird.

6. Verfahren nach einem der Ansprüche 1 bis 5,
woei die maximale Sendeleistung nach dem Strom geschätzt wird, der durch die Stromversorgung (16) geliefert wird.

7. Verfahren nach einem der Ansprüche 1 bis 5,
wobei die maximale Sendeleistung nach der Spannung der Stromversorgung (16) geschätzt wird.

8. Verfahren nach einem der Ansprüche 1 bis 5,
wobei die maximale Sendeleistung nach der Temperatur der Stromversorgung (16) geschätzt wird.

9. Verfahren nach Anspruch 1,
wobei das Gerät (1) deklassiert wird, indem jegliches Senden von Sprachsignalen gesperrt und der Empfang von Meldungen, die vom Netz (2) herrühren, aufrechterhalten wird.

10. Verfahren nach Anspruch 9,
wobei das Gerät (1) Mittel einer Mensch-Maschine-Beziehung aufweist, und wobei in den Meldungen eine ein anrufendes Gerät identifizierende Nummer erkannt wird, die auf die Mittel einer Mensch-Maschine-Beziehung angewandt bzw. bezogen wird.

11. Verfahren nach Anspruch 9,
wobei das Gerät (1) Mittel einer Mensch-Maschine-Beziehung aufweist, und wobei jegliches Senden gesperrt wird und der Eingang eines Rufes erkannt wird, was durch die Mittel einer Mensch-Maschine-Beziehung angezeigt wird.

## Claims

1. Method for managing the power supply (16) of a mobile telephone set (1) of a cellular radiotelephone network (2), the transmission power (13) of which is controlled (14) by the network according to a power class indicated by the set (1), a method **characterised by** the fact that
- the charge level of the power supply (16) is determined,
- the maximum transmission power attainable is deduced from the charge level,
- the maximum transmission power and the transmission power controlled (14) by the network (2) are compared, and
- the mobile set (1) is downgraded if the former is less than the latter (14).

2. Method according to claim 1, wherein, in order to be downgraded, the set (1) rejects the power control of the network.

3. Method according to claim 1, wherein the set (1) is downgraded into a fictitious class with a transmission power lower than that of the nominal class.

4. Method according to claim 3, wherein every link between the set (1) and the network (2) is broken in order then to re-establish such a link and transmit the indication relating to the fictitious class.

5. Method according to claim 4, wherein the link is broken by cutting off the power supply (16) to the set (1).

6. Method according to one of claims 1 to 5, wherein the maximum transmission power is estimated according to the current output by the power supply (16).

7. Method according to one of claims 1 to 5, wherein the said maximum transmission power is estimated according to the voltage of the power supply (16).

8. Method according to one of claims 1 to 5, wherein the maximum transmission power is estimated according to the temperature of the power supply (16).

9. Method according to claim 1, wherein the station (1) is downgraded by barring any transmission of voice signals, and the reception of messages coming from the network (2) is maintained.

10. Method according to claim 9, wherein, the set (1) comprising man-machine communication means, a number identifying a calling set is detected in the messages and this number is applied to the man-machine communication means.

11. Method according to claim 9, wherein, the set (1) comprising man-machine communication means, all transmission is barred and the arrival of a call is detected, which is signalled by the man-machine communication means.
